# EUROPEAN PATENT APPLICATION

(11) **EP 4 637 029 A1**
(43) Date of publication of application: **22.10.2025**
(21) Application number: 25168714.1
(22) Date of filing: 04.04.2025
(51) Int. Cl.: H03F 1/02, H03F 1/52, H03F 3/193, H03F 3/24, H03F 3/68

(54) **FAULT PROTECTION OF SYMBOL BASED ENVELOPE TRACKERS**

(30) Priority: 18.04.2024 US 202463635820 P
(71) Applicant: Analog Devices, Inc., Wilmington, MA 01887 (US)
(72) Inventor: Sapia, Gary A., Wilmington, 01887 (US); Gardner, Andrew J., Wilmington, 01887 (US)
(74) Representative: Wallin, Nicholas James

(57) **Abstract**

Aspects of this disclosure relate to a power amplifier system with symbol-based envelope tracking and fault protection. The system can include a power amplifier and a voltage modulator. The voltage modulator can include switches configured to provide the bias voltage and to provide electric circuit breaker protection. The voltage modulator can include a fault detection circuit that can cause a switch of the switches to provide electric circuit breaker protection in response to detecting a circuit fault. Related methods and voltage modulators are disclosed.

## Description

### CROSS REFERENCE TO PRIORITY APPLICATION

This application claims the benefit of priority of U.S. Provisional Application No. 63/635,820, filed April 18, 2024 and titled "FAULT PROTECTION OF SYMBOL BASED ENVELOPE TRACKERS," the disclosure of which is hereby incorporated by reference in its entirety and for all purposes.

### BACKGROUND

### TECHNICAL FIELD

Embodiments of this disclosure relate to fault protection in electronic systems.

### DESCRIPTION OF RELATED TECHNOLOGY

Radio systems can transmit and receive signals in the form of electromagnetic waves having a frequency in range from approximately 30 kilohertz (kHz) to 300 Gigahertz (GHz). Radio systems can be used for wireless communications, such as cellular communications and/or other wireless network communications.

Radio systems that transmit signals often include a power amplifier to amplify a radio frequency (RF) signal for transmission via one or more antennas. Power amplifiers can consume significant power in such systems. Power efficient power amplifiers can be desirable for a variety of applications.

### SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is a system with symbol-based envelope tracking and fault protection. The system includes a power amplifier and a symbol-based envelope tracking voltage modulator. The power amplifier is configured to amplify a radio frequency signal. The symbol-based envelope tracking voltage modulator is configured to receive a plurality of supply voltages and to provide a bias voltage to the power amplifier. The bias voltage corresponds to a selected one of the plurality of supply voltages. The symbol-based envelope tracking voltage modulator includes switches and a fault detection circuit. The switches are configured to provide the bias voltage and to provide electric circuit breaker protection. The fault detection circuit is coupled to at least a first switch of the switches. The fault detection circuit is configured to detect a circuit fault and to cause the first switch to provide electric circuit breaker protection in response to detecting the circuit fault.

The system can include a plurality of voltage supplies configured to provide the plurality of supply voltages. The plurality of voltage supplies can include a first voltage supply connected to the first switch, where the first switch is configured to electrically isolate the first voltage supply from the power amplifier in response to the fault detection circuit detecting the circuit fault.

The fault detection circuit can be coupled to a second switch of the switches. The fault detection circuit is configured to detect a second circuit fault and to cause the second switch to provide electric circuit breaker protection in response to detecting the second circuit fault.

The system can include a plurality of additional power amplifiers and a plurality of additional symbol-based envelope tracking voltage modulators each configured to selectively provide a first supply voltage of the plurality of supply voltages to a respective power amplifier of the plurality of additional power amplifiers while the first switch provides electric circuit breaker protection associated with the first supply voltage.

The circuit fault can be an overcurrent fault associated with the power amplifier.

The fault detection circuit can include a comparator. The fault detection circuit can include a replica switch of the first switch.

The fault detection circuit can include a sense resistor in series between the first switch and the power amplifier.

The first switch can include a metal oxide field effect transistor.

The first switch can include back-to-back field effect transistors to junction isolate an input node of the symbol-based envelope tracking voltage modulator from an output node of the symbol-based envelope tracking voltage modulator.

The power amplifier can include a gallium nitride power amplifier transistor.

Another aspect of this disclosure is a method of fault protection in a power amplifier system. The method includes providing, with a voltage modulator, a first supply voltage as a bias voltage for a power amplifier in a first state using a first switch; providing, with the voltage modulator, a second supply voltage as the bias voltage for the power amplifier in a second state using a second switch, wherein the first and second supply voltages are non-zero voltages; in the second state, detecting a circuit fault associated with the power amplifier; and in response to said detecting, electrically isolating a voltage supply that generates the second supply voltage from the power amplifier using the second switch.

The method can include providing the second supply voltage to a plurality of other power amplifiers using other voltage modulators during said electrically isolating.

The circuit fault can be an overcurrent fault.

The second switch can include back-to-back transistors that junction isolate the voltage supply from an output node of the voltage modulator.

The bias voltage can track an envelope of a radio frequency signal amplified by the power amplifier on a symbol-by-symbol basis.

Another aspect of this disclosure is a voltage modulator with fault protection. The voltage modulator includes input nodes, an output node, a first switch, a second switch, and a fault detection circuit. The input nodes include a first input node configured to receive a first supply voltage and a second input node configured to receive a second supply voltage. The first and second supply voltages are non-zero voltages. The first switch is configured to pass the first supply voltage to the output node in a first state. The second switch is configured to pass the second supply voltage to the output node in a second state. The fault detection circuit is coupled to at least the first switch. The first switch is configured to electrically isolate the first input node from the output node in response to an output signal of the fault detection circuit indicating a circuit fault.

The fault detection circuit can include a comparator.

The fault detection circuit can include a replica of the first switch.

A voltage at the output node can track an envelope of a radio frequency signal on a symbol-by-symbol basis.

For purposes of summarizing the disclosure, certain aspects, advantages and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

### BRIEF DESCRIPTION OF THE DRAWINGS

Embodiments of this disclosure will be described, by way of non-limiting example, with reference to the accompanying drawings.
Figure 1 is a waveform of a radio frequency (RF) signal and a modulated bias voltage that changes on a symbol-by-symbol basis.
Figure 2 is a schematic block diagram of a multiple-input, multiple-output (MIMO) radio system according to an embodiment.
Figure 3 is a schematic diagram of a radio transmitter channel with a dual input bias voltage multiplexer for biasing an RF power amplifier.
Figure 4 is a schematic diagram of a dual input, single output embodiment of a symbol-based envelope tracking (SBET) voltage modulator.
Figure 5 is a schematic diagram of a four input, single output embodiment of a SBET voltage modulator.
Figure 6 is a schematic diagram of that includes circuitry for sensing a switch current that includes a comparator according to an embodiment.
Figure 7 is a schematic diagram of that includes circuitry for sensing a switch current that includes a replica switch according to another embodiment.
Figure 8 is a schematic diagram of that includes circuitry for sensing a switch current that includes a sense resistor according to another embodiment.
Figure 9 is a schematic diagram that includes a dual input, single output SBET voltage modulator with electronic circuit breaker functionality using a plurality of current sense schemes according to an embodiment.
Figure 10A is a schematic diagram of part of a system with redundant fault protection according to an embodiment.
Figure 10B is a schematic diagram of part of a system with redundant fault protection according to another embodiment.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings. The headings provided herein are for convenience only and do not necessarily affect the scope or meaning of the claims.

A rapidly growing use of power supplies is to bias radio frequency (RF) power amplifiers (PAs) in multiple-input multiple-output (MIMO) cellular radios. These PAs may be configured as linear amplifiers, instead of Class-D amplifiers or other switching amplifiers, due to specifications to support high frequency transmission. Two or more power supply voltages may be used to modulate the bias voltage of the PA between two or more discrete voltage levels to track an RF envelope of a symbol being amplified by the PA on a symbol-by-symbol basis to reduce and/or minimize power dissipation.

Certain PA transistors can be sensitive. For example, gallium nitride (GaN) PA field effect transistors can be sensitive to a gate bias voltage. Such PA transistors can experience circuit faults, such as an overcurrent fault. The circuit fault can be a result of shorting in the PA. Protecting power supplies from a circuit fault associated with a PA can be a system level specification.

Fault protection in PA systems can include a fault protection device that can electrically isolate a voltage supply from the transmit channels in the event of a fault. Certain fault protection devices can electrically isolate the voltage supply from all PAs in a system in a fault condition. In such a case, one faulty PA can halt operation of all PAs in the system.

Aspects of this disclosure relate to a voltage modulator that includes a switch that passes a supply voltage from a voltage supply and can also electrically isolates the voltage supply from a power amplifier in response to a circuit fault associated with the power amplifier being detected. This can electrically isolate the power amplifier with a circuit fault from the voltage supply while other voltage modulators provide the supply voltage from the voltage supply to other power amplifiers. Accordingly, the system can include fault protection and continue operation with other PAs that are functioning under operational parameters. Fault protection in this disclosure can ensure that switches of the voltage modulator are protected. A switch of the voltage modulator that implements fault protection can include a field effect transistor, such as a metal oxide semiconductor field effect transistor (MOSFET). The voltage modulator can provide a bias voltage to the PA that tracks an envelope of an RF signal for amplification by the PA on a symbol-by-symbol basis.

### SBET Envelope Tracking

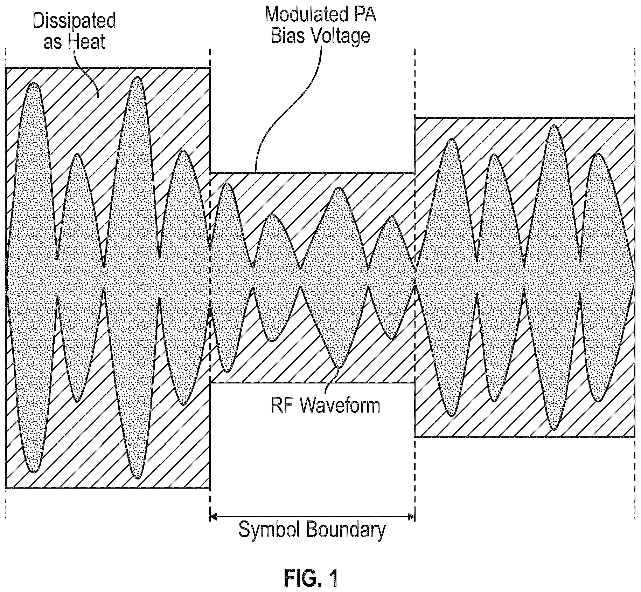

Figure 1 illustrates an example waveform where the PA bias voltage is modulated on a symbol-by-symbol basis to reduce power dissipation. The PA bias voltage is modulated as a function of the RF waveform. Such bias voltage modulation can reduce power dissipation by the PA. Dissipated heat can correspond to a difference between the RF waveform and the PA bias voltage. The PA bias voltage can toggle among discrete voltage levels on a symbol-by-symbol basis. Such a technique can be referred to as symbol-based envelope tracking (SBET). The PA bias voltage can track a root mean square symbol power of a RF signal in SBET.

**In** SBET, a PA transistor output terminal bias voltage (e.g., drain bias voltage) may only change on symbol boundaries, for example, as shown in the Figure 1. The bias voltage provided to a PA transistor output terminal (e.g., a drain of a PA field effect transistor) can have a generally constant voltage level for an entire symbol in SBET while the envelope of the waveform has multiple peaks and troughs for the symbol. The PA transistor output terminal bias voltage can support a maximum peak power within a symbol. This can improve PA efficiency relative to a using fixed PA bias voltage. At the same time, SBET can be implemented with less complexity and with a slower switching time than continuous envelope tracking.

In the case of mixed numerology carriers (for example, in fifth generation New Radio), the symbols lengths are shorter for the higher numerologies. In this case, SBET can switch at the symbol boundaries of the highest numerology carrier in some instances. Alternatively, SBET can switch at the symbol boundaries of the lowest numerology carrier in some other instances. In either mixed numerology carrier case, a bias voltage provided by a SBET voltage modulator may change only on symbol boundaries and the bias voltage is generally constant during each symbol.

Any suitable combination of features of SBET disclosed in one or more of U.S. Patent Publication No. 2024/0405725, U.S. Patent Publication No 2025/0015769, or U.S. Patent Publication No. 2025/0015762 can be implemented in combination with SBET features disclosed herein. The technical disclosures of each of U.S. Patent Publication No. 2024/0405725, U.S. Patent Publication No 2025/0015769, and U.S. Patent Publication No. 2025/0015762 are hereby incorporated by reference in their entireties and for all purposes.

### Radio Systems and Transmitter Channels

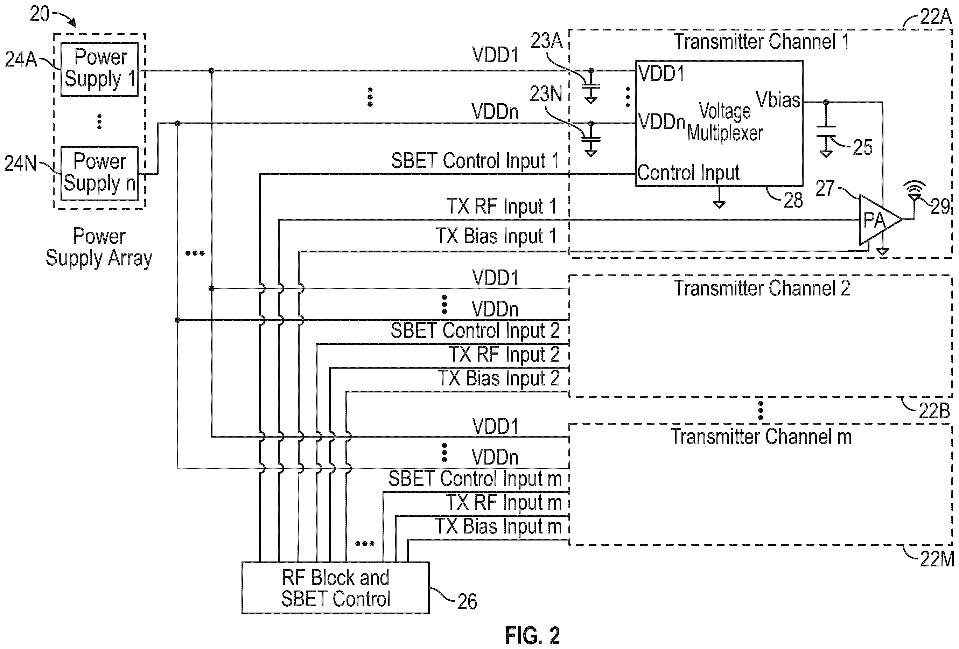

Figure 2 is a schematic block diagram of an example MIMO radio system 20 according to an embodiment. As illustrated, the MIMO radio system 20 includes a plurality of transmitter channels 22A, 22B, 22M, a plurality of power supplies 24A, 24N, and an RF and SBET control block 26. The transmitter channels 22A, 22B, 22M can be referred to as RF PA transmitter channels. The plurality of transmitter channels 22A, 22B, 22M can each include a PA 27, bypass capacitors 23A to 23N, a voltage multiplexer 28, and an antenna 29. A load capacitance 25 is also illustrated in the transmitter channel 22A. A voltage modulator circuit can include the bypass capacitors 23A, 23N and the voltage multiplexer 28. Any suitable positive integer number M of transmitter channels can be implemented. In certain applications, there can be 8 to 128 transmitter channels. For example, there can be 32, 64, or 128 transmitter channels in some applications.

The voltage multiplexer 28 can implement SBET biasing of the PA 27. The voltage multiplexer 28 can have two or more supply voltage inputs and one output. The supply voltage inputs of the voltage multiplexer 28 are configured to receive voltages generated from respective power supplies 24A, 24N. As illustrated in Figure 2, the power supplies 24A, 24N can be included in a power supply array. Any suitable positive integer number N of power supplies can be implemented. For example, in certain applications, there can be 2 power supplies or 4 power supplies. The output of the voltage multiplexer 28 can be connected to the PA 27 to provide a bias voltage Vbias for the PA 27. Input bypass capacitors 23A and 23N can be positioned in proximity with the voltage multiplexer 28 to reduce and/or minimize parasitic inductance.

Supply voltages VDD1 to VDDn from the power supplies 24A, 24N can be provided to two or more transmitter channels 22A, 22B, 22M. The supply voltages VDD1 to VDDn can also be referred to as power supply voltages. The power supplies 24A to 24N can be implemented as discrete voltage sources. The power supplies 24A to 24N can be implemented as voltage sources in series. Each of the power supplies 24A to 24N can provide a non-zero supply voltage.

The RF and SBET control block 26 can generate an RF input signal (e.g., one of TX RF Input 1 to TX RF Input M) for the PA 27, a second bias input signal (e.g., one of TX Bias Input 1 to TX Bias Input M) for the PA 27, and one or more voltage multiplexer control signals (e.g., one of SBET Control Input 1 to SBET Control Input M) for each transmitter channel 22A to 22M. The one or more voltage multiplexer control signals can control switches of the voltage multiplexer 28 to select a bias voltage Vbias that tracks the envelope of the RF signal. Each voltage multiplexer 28 can include a decoder to decode the one or more voltage multiplexer control signals in certain applications. A voltage level of the bias voltage Vbias can be adjusted corresponding to symbol boundaries of the RF signal. The bias voltage Vbias can track the envelope of the RF signal on a symbol-by-symbol basis. In some instances, the bias voltage Vbias can track the envelope of the RF signal for a group of symbols and/or for each individual symbol. The bias voltage Vbias can be applied to an output (e.g., a drain) of the PA 27. The second bias input signal for the PA 27 can be a bias signal for an input terminal (e.g., a gate) of the PA 27.

The power delivered from the power supplies 24A, 24N can be limited by circuit breakers and/or fuses. Alternatively, the voltage multiplexer 28 can incorporate electronic circuit breaker protection. In such instances, the voltage multiplexer 28 of each transmitter channel 22A to 22M can provide electronic circuit breaker (ECB) protection. More details regarding providing ECB protection with voltage multiplexers will be discussed later.

The PA 27 can amplify the RF input signal. The PA 27 can be implemented by any suitable transistors. In certain applications, the PA 27 can include a GaN transistor, such as a GaN field effect transistor. The antenna 29 can be coupled to the output of the PA 27. Although not shown in Figure 2, a direct current (DC) blocking capacitor can be coupled between The output of the PA 27 and the antenna 29. The antenna 29 can transmit an output signal. Antennas 29 of the transmitter channels 22A, 22B, 22M can perform beamforming in certain applications.

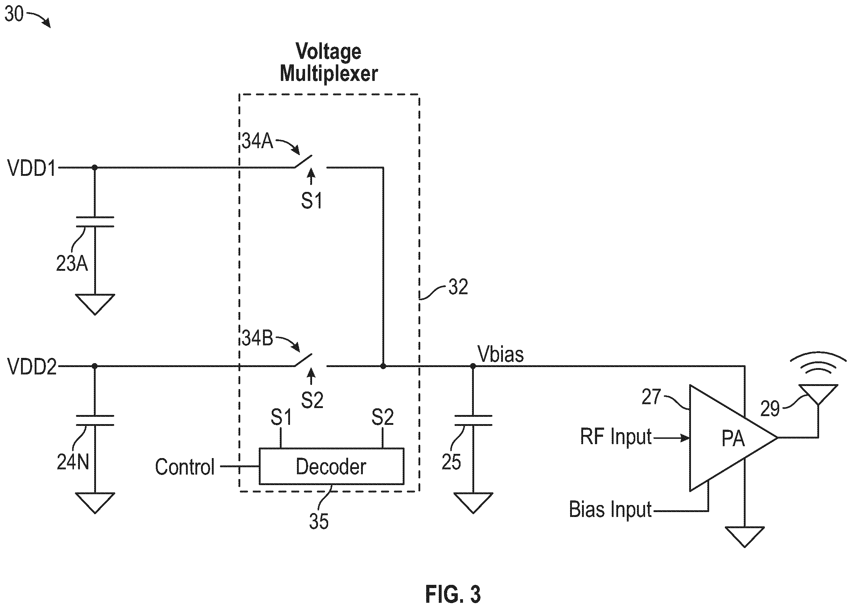

Figure 3 is a schematic diagram of a transmitter channel 30 with a dual input bias voltage multiplexer 32 for biasing a PA 27. The transmitter channel 30 is configured to receive two different supply voltages VDD1 and VDD2. The voltage multiplexer 32 is configured to modulate the bias voltage Vbias by actuating switches 34A and 34B to selectively electrically connect input nodes at the supply voltages VDD1 and VDD2, respectively, to the output node that provides the bias voltage Vbias. The voltage multiplexer 32 can include a decoder 35 to control switching of the switches 34A and 34B to generate the bias voltage Vbias at discrete voltage levels. The decoder 35 can provide binary output signals to control switches 34A and 34B. The decoder 35 can decode a control signal Control. In some applications, the decoder 35 can receive a ternary level input control signal to actuate the switches 34A and 34B where the third level is decoded to open both switches simultaneously. The control signal Control can be provided by a control block, such as the RF and SBET control block 26 of Figure 2.

### Fault Protection with SBET Voltage Modulator

Protecting power supplies at inputs of an SBET voltage modulator from a PA circuit fault can be a system level specification. The circuit fault can be a PA short circuit fault. The SBET voltage modulator switches can be used to implement an electronic circuit breaker (ECB) to meet the fault protection specifications. This approach can advantageously ensure that the switches of the SBET voltage modulator are also protected. Such switches can include MOSFET switches.

Embodiments of this disclosure utilize one or more MOSFET switches of a SBET voltage modulator to sense output current and isolate an overcurrent fault at the PA from one or more power supplies at the input side of the SBET voltage modulator. Back-to-back MOSFET switches may be employed to junction isolate one or more of the power supply inputs from the switched output node SW of the SBET voltage modulator.

Systems with SBET and fault detection are disclosed. A system can include a PA and an SBET voltage modulator. The SBET voltage modulator can receive a plurality of supply voltages and provide a bias voltage to the power amplifier. The bias voltage can correspond to a selected one of the plurality of supply voltages. The SBET voltage modulator can include switches to provide the bias voltage and ECB protection. The SBET voltage modulator can include a fault detection circuit to detect a circuit fault and to cause a switch of the switches to provide ECB protection in response to detecting the circuit fault.

Cellular MIMO base station radios typically have a relatively large number of RF PAs operating from one or more input power supplies. For example, the MIMO radio system 20 of Figure 2 can include 32, 64, or 128 transmitter channels in certain applications. In the event of a fault at the PA, it can be desirable to isolate the PA from the base station power supplies. The PAs may also include field effect transistors with their drain voltages dynamically modulated on a symbol-by-symbol basis. SBET may be implemented on a per transmitter channel basis by a dedicated voltage modulator for teach transmittal channel. For instance, each transmitter channel can include a voltage modulator implemented in accordance with any suitable principles and advantages discussed with reference to any of Figures 1, 2, and/or 3.

The voltage modulators may include MOSFET switches in a half bridge configuration. Due to a relatively large number of RF PAs and associated components, isolating each PA channel from power supplies of the system can be significant for preserving the up-time of a base station that includes such RF PAs. Reducing and/or minimizing component count and cost in MIMO base stations is desirable. Integrating an electronic circuit breaker function into the same solution as the SBET voltage modulator can reduce component count and meet technical specifications for fault protection. At the same time, switches (e.g., MOSFETs) of the SBET voltage modulator can be protected during a fault.

An integrated SBET voltage modulator and ECB may use drain to source voltage sensing of one or more field effect transistors of the SBET volage modulator to measure output current. If the current exceeds a preset threshold, the ECB may trip and isolate the input power supplies from the switched output node. The ECB may retry or latch off. The manner in which the voltage modulator switches (e.g., MOSFETs) are cutoff in response to a fault may be substantially slower than for normal operation of the SBET voltage modulator.

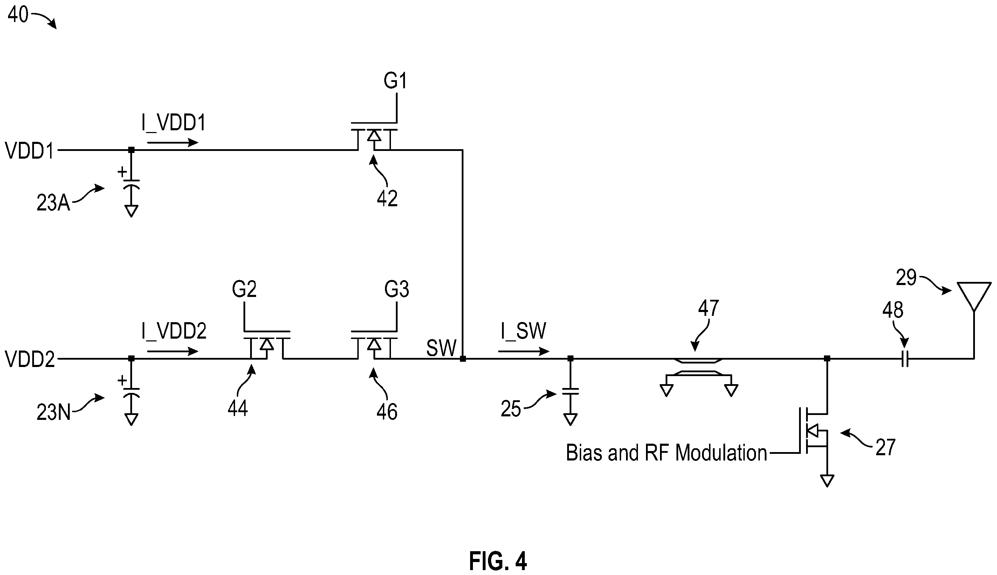

Figure 4 illustrates an embodiment of a dual input, single output SBET voltage modulator 40 with switches 42, 44, and 46. The switches 42, 44, and 46 can be MOSFET switches as illustrated. While the description of Figure 4 and other figures may refer to MOSFET switches, any other suitable switches can alternatively or additionally be implemented. MOSFET switches disclosed herein can be enhancement mode MOSFET switches in certain applications. The MOSFET switch 42 can connect the output node SW to the first supply voltage VDD1. The MOSFET switches 44 and 46 can connect the output node SW to the second supply voltage VDD2. The MOSFET switches 44 and 46 can be common-drain, back-to-back MOSFET switches, for example, as illustrated in Figure 4.

The SBET modulator 40 is configured to receive supply voltages VDD1 and VDD2. The supply voltages VDD1 and VDD2 are non-zero voltages. The supply voltages VDD1 and VDD2 can differ from each other by at least 10 V or at least 20 V. The supply voltage of the supply voltages VDD1 and VDD2 with a lower voltage can have a voltage that is at least one quarter of the voltage of the supply voltage with the higher voltage level. In some such instances, the supply voltage with the lower voltage can have a voltage that is at least one half of the voltage of the supply voltage of the supply voltage with the higher voltage level. As one example, the supply voltage with the higher voltage level can have a voltage of 48 V and the supply voltage with the lower voltage level can have a voltage of 24 V.

The SBET voltage modulator 40 is configured to output a selected one of the supply voltages VDD1 and VDD2 at the output node SW based on a SBET state. The SBET state can correspond to a supply voltage of the supply voltages VDD1 and VDD2. The SBET state can correspond to a peak signal power of a symbol of an RF signal being amplified by the power amplifier 27. The peak power can be a peak root mean square (RMS) signal power. The SBET state can correspond to a peak composite power symbol of an RF signal amplified by the power amplifier 27, where the RF signal includes a plurality of carriers.

In a first state, the MOSFET switch 42 can pass the first supply voltage VDD1 to the output node SW. Current I_VDD1 can be provided to the MOSFET switch 42. When the output node SW is connected to the first supply voltage VDD1, the MOSFET switch 42 can be enhanced by pulling its gate G1 high with respect to its source voltage, the first supply voltage VDD1. The MOSFET switches 44 and 46 can both be cut-off by pulling gates G2 and G3 to their respective source terminals, the second supply voltage VDD2 for the MOSFET switch 44 and the output node SW for the MOSFET switch 46.

In a second state, the MOSFET switches 44 and 46 can pass the second supply voltage VDD2 to the output node SW. Current I_VDD2 can be provided to the MOSFET switch 44. When the output node SW is connected to the second supply voltage VDD2, MOSFET switches 44 and 46 can be enhanced by pulling gates G2 and G3 high with respect to the second supply voltage VDD2 and the output node SW, respectively, and the MOSFET switch 42 can be cutoff by pulling its gate G1 to the output node SW.

The SBET voltage modulator 40 may sense a current I_SW flowing out of the output node SW. The output node SW can be a pin in certain applications. The SBET voltage modulator 40 can include a fault detection circuit (not illustrated in Figure 4) that can sense current and detect a circuit fault. The fault detection circuit can include any suitable circuitry to detect a circuit fault, such as one or more of a comparator, a replica switch, a sense resistor, or the like. The fault detection circuit can cause a switch of the SBET voltage modulator 40 to provide ECB protection. This can electrically isolate a voltage supply from a circuit fault, such as an overcurrent fault associated with the power amplifier 27.

If the sensed current exceeds a preset threshold, the MOSFET switches 42, 44, and 46 may be cut-off so as to electrically isolate the PA 27 connected to the output node SW from the first supply voltage VDD1 and the second supply voltage VDD2. Some of the MOSFET switches 42, 44, 46 may already be cut-off when a circuit fault is detected. Any suitable subset of the MOSFET switches 42, 44, 46 can be cut-off in response to detecting a circuit fault. The rate at which the MOSFET switch or switches are cut-off for providing electrical isolation in response to detecting a circuit fault may be substantially slower than for normal operating conditions. This may be done to reduce and/or minimize voltage transients at the input or inputs (VDDn) and switched output node SW of the SBET voltage modulator 40 resulting from the time rate of change, dI/dt, in the MOSFET terminal currents.

The voltage drop across a MOSFET switch may be used to sense the current I_SW flowing out of a pin at the output node SW. For example, when the MOSFET switch 42 is enhanced and the MOSFET switches 44 and 46 are cut-off, the drain-to-source voltage of the MOSFET switch 42 may be used to measure current I_SW at the output node SW. Similarly, when the MOSFET switch 42 is cut-off and the MOSFET switches 44 and 46 are enhanced, the source-to-drain voltage of the MOSFET switch 44, the drain-to-source voltage of the MOSFET switch 46, or the sum of the source-to-drain voltage of the MOSFET switch 44 and the drain-to-source voltage of the MOSFET switch 46 may be used to measure current I_SW at the output node SW.

Figure 4 also illustrates a transmission line 47 and a DC blocking capacitor 48 in a signal path between the output node SW and the antenna 29. The transmission line 47 can be a quarter wavelength transmission line. The DC blocking capacitor 48 can block a DC signal component. Although not illustrated in Figures 2 and 3, a transmission line and DC blocking capacitor can be implemented in these embodiments like in Figure 4.

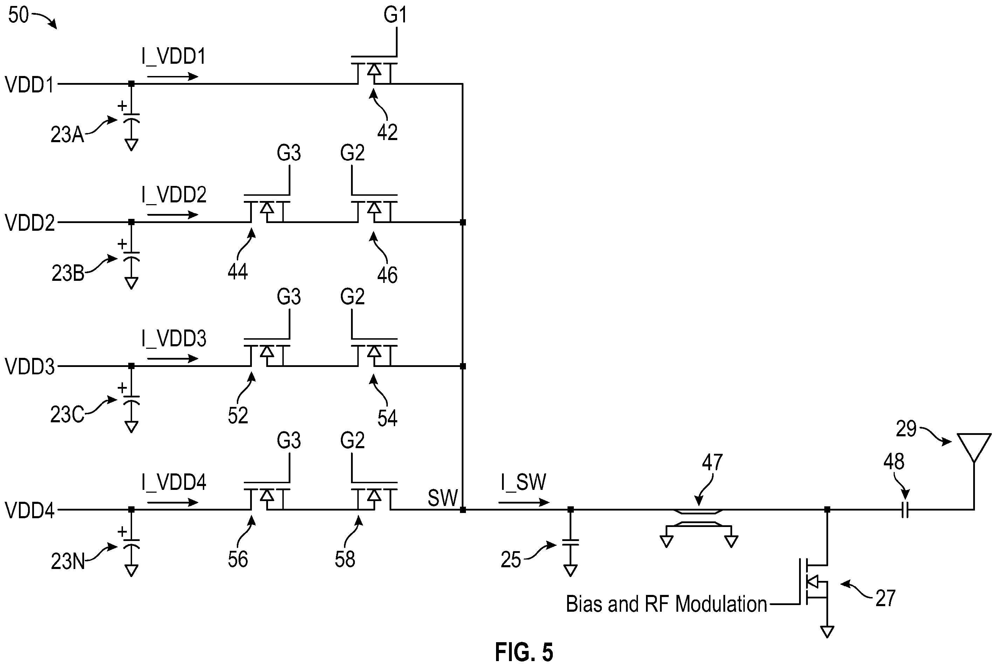

Figure 5 illustrates a four input, single output embodiment of a SBET voltage modulator 50. The BSET voltage modulator receives supply voltages VDD1 to VDD4. The supply voltages VDD1 to VDD4 are each non-zero voltages. The MOSFET switch 42 can connect the first supply voltage VDD1 to the output node SW. Common-source, back-to-back MOSFET 44 and 46, 52 and 54, 56 and 58 can junction isolate the output node SW from the second, third, and fourth supply voltagesVDD2, VDD3, and VDD4 inputs, respectively, in this embodiment. Accordingly, a switch of a voltage modulator can include common source, back-to-back MOSFETs. In some other applications, a switch can include a MOSFET in series with a diode. A MOSFET in series with a diode can be implemented in place common source, back-to-back MOSFETs.

As with the dual input, single output SBET voltage modulator 40 of Figure 4, one or more MOSFET switch voltage drops may be used to sense the current I_SW at the output node SW of the SBET voltage modulator 50. If the sensed current exceeds a preset threshold, the MOSFET switches 42, 44, 46, 52, 54, 56, 58 may be cut-off thus isolating the output node from the voltage supplies VDD1 to VDD4 at the inputs of the SBET voltage modulator 50. Any suitable fault detection circuit disclosed herein can be include in the SBET voltage modulator 50. Various MOSFET switches of the SBET voltage modulator 50 may already be cut-off when a circuit fault is detected. Any suitable subset of the MOSFET switches 42, 44, 46, 52, 54, 56, 58 can be cut-off in response to detecting a circuit fault.

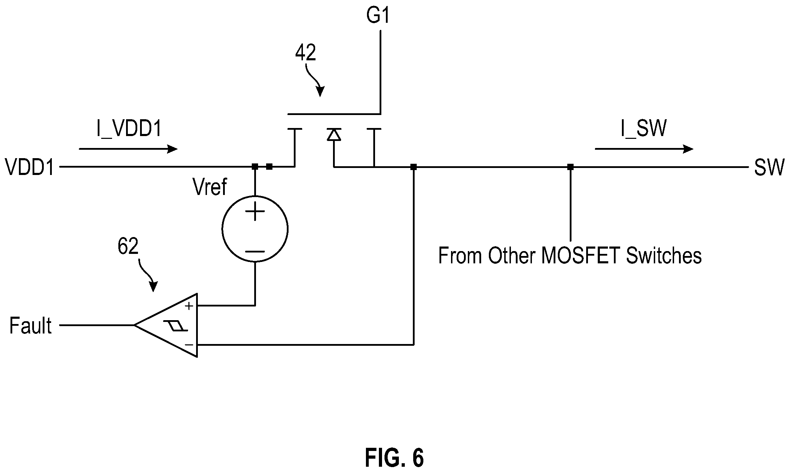

Figure 6 illustrates a scheme for sensing a MOSFET switch current. In Figure 6, a fault detection circuit for detecting a circuit fault includes a comparator 62. As illustrated, the inverting input of the comparator 62 is connected to the source terminal of MOSFET switch 42 and the non-inverting input of the comparator 62 is connected to an offset voltage with respect to the drain of the MOSFET switch 42. The offset voltage Vref can be selected to correspond to the voltage drop between the drain and source terminals of the MOSFET switch 42 at a desired over-current limit threshold. When the drain-to-source voltage of the MOSFET switch 42 exceeds the offset voltage Vref, the comparator 62 can trip, indicating an over-current fault has occurred. Using the comparator 62, an overcurrent fault can be detected relatively fast. For example, the comparator 62 can respond to an overcurrent fault in nanoseconds.

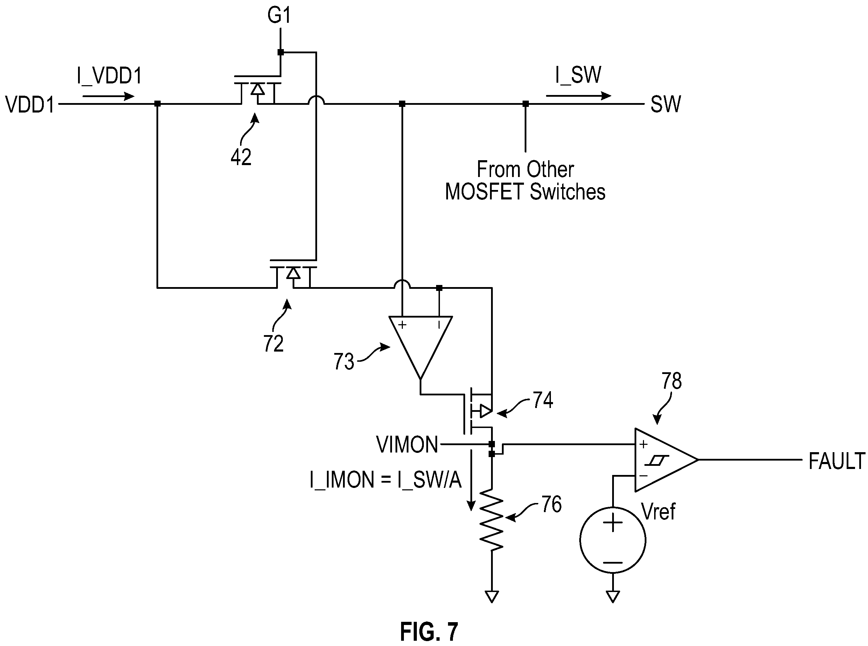

Figure 7 illustrates another scheme for sensing MOSFET switch current. In Figure 7, a fault detection circuit for detecting a circuit fault includes a replica MOSFET 72, an error amplifier 73, a bias MOSFET 74, a resistor 76, and a comparator 78. In this embodiment, a replica MOSFET 72 with gate width equal to 1/A times the gate width of the MOSFET switch 42 can be identically biased to the MOSFET switch 42. The gate width of the replica MOSFET 72 can be 1/1000 of a gate width of the MOSFET 42 or less in certain applications.

Error amplifier 73 can sense a source voltage of the MOSFET switch 42 and servo a gate of P-channel bias MOSFET 74 to force the voltage difference between the inverting and non-inverting inputs of the error amplifier 73 to zero. The resulting current I_IMON flowing out of the drain of the P-channel bias MOSFET 74 can be forced through resistor 76 to generate a voltage VIMON proportional to drain current of the MOSFET switch 42. The current I_IMON can be equal to or approximately equal to the current I_SW flowing out of the output node SW times the ratio 1/A of gate widths of the replica MOSFET 72 divided by the MOSFET 42A.

The voltage VIMON across the resistor 76 may be compared by a comparator 78 against a reference voltage Vref to determine if an over-current fault has occurred. The resistor 76 may be a discrete component. The fault detection of Figure 7 can be slower relative to the fault detection of Figure 6. The fault detection circuits of Figure 6 and Figure 7 can both detect overcurrent faults. Such faults can be associated with a PA.

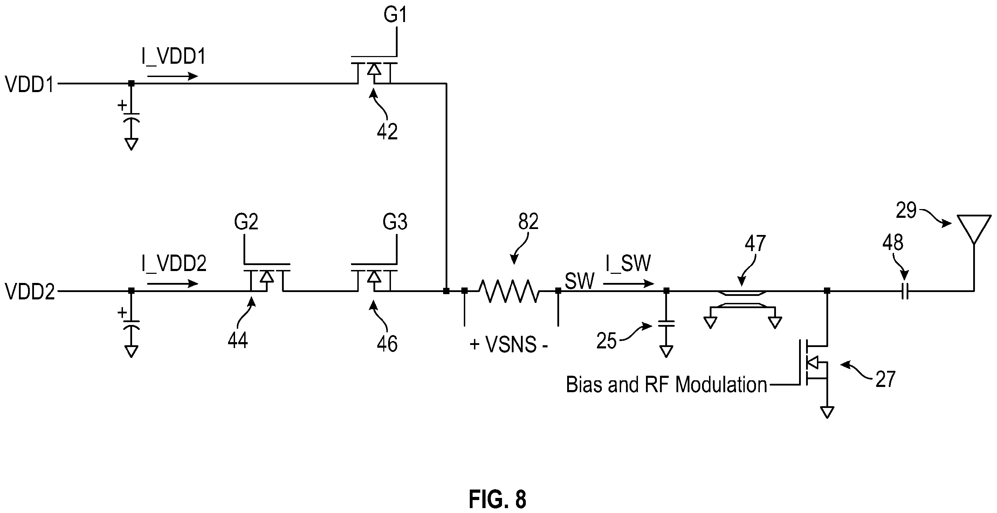

Figure 8 illustrates a current sense scheme where current I_SW at the output node SW of a voltage modulator is measured directly using current sense resistor 82. The resulting voltage VSNS across the sense resistor 82 may be amplified before being compared against the ECB's threshold voltage in certain applications. In such applications, a fault detection circuit can include the sense resistor 82, an amplifier, and a comparator.

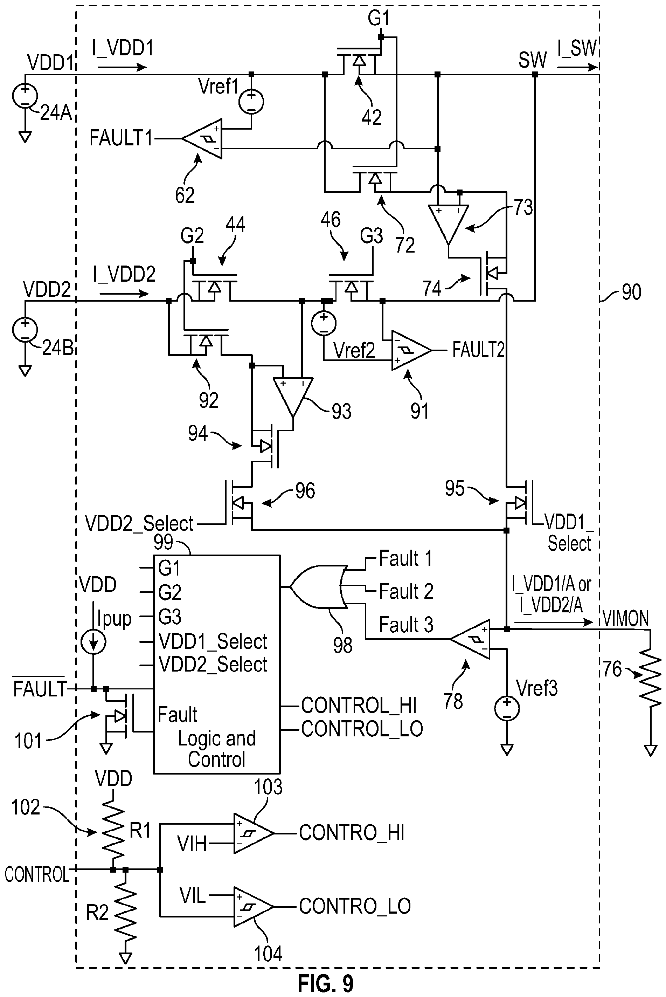

Figure 9 illustrates a dual input, single output SBET voltage modulator 90 with ECB functionality using a plurality of the MOSFET current sense schemes discussed above. In the SBET voltage modulator 90, a fault detection circuit includes a comparator 62, a replica MOSFET switch 72, an error amplifier 73, a bias MOSFET 74, a resistor 76, and a comparator 78, a MOSFET switch 95, comparator 91, a replica MOSFET switch 92, an error amplifier 93, and a bias MOSFET 96. The fault detection circuit can detect circuit faults and cause some or all of the MOSFET switches 42, 44, and 46 to provide ECB protection in response to detecting a circuit fault. The SBET voltage modulator 90 includes fault detection using comparators and fault detection using replica switches.

The SBET voltage modulator 90 includes a comparator 62 that can compare a voltage to the source terminal of MOSFET switch 42 with a first reference voltage Vref1 relative to a voltage at the drain terminal of the MOSFET switch 42 to detect whether an over-current fault has occurred. The comparator 62 of the SBET voltage modulator 90 can function like the compactor 62 of Figure 6. The SBET voltage modulator 90 also includes a second comparator 91 that can compare a voltage to the source terminal of MOSFET switch 46 with a second reference voltage Vref2 relative to a voltage at the drain terminal of the MOSFET switch 46 to detect whether an over-current fault has occurred. The second comparator 91 is electrically connected to the MOSFET switch 46 that is coupled to the voltage supply 24B via the MOSFET switch 44. This can provide relatively fast fault detection closer to the PA that is connected to the output node SW. Although not shown in Figure 9, a PA and associated circuitry can be connected to the output node SW like shown in Figures 4, 5, and 8.

The SBET voltage modulator 90 includes fault detection using a replica MOSFET 72. The replica MOSFET 72, the error amplifier 73, the bias MOSFET 74, the resistor 76, and the comparator 78 can function like described with reference to Figure 7. The SBET voltage modulator 90 also includes fault detection using replica MOSFET 92 that is a replica of the MOSFET switch 44. The replica MOSFET 92, second error amplifier 93, and second bias MOSFET 94 can provide similar fault detection associated with the second supply voltage VDD2 as the replica MOSFET 72, the error amplifier 73, and the bias MOSFET 74 provide in association with the first supply voltage VDD1. The SBET voltage modulator 90 also includes MOSFET switches 95 and 96 to selectively electrically connect fault detection circuitry associated with the MOSFET switch 42 or 44 that is on to the comparator 78.

A control circuit can control MOSFET switches of the voltage modulator 90 to electrically isolate a power amplifier from a power supply in response to an output of the fault detection circuit detecting a circuit fault. The control circuit can include control logic 99. The control circuit can also include fault logic 98 and comparators 103 and 104. Fault logic 98 can provide a fault signal to control logic 99 to indicate a circuit fault. The circuit fault can be associated with the power amplifier. The circuit fault can be an overcurrent fault. As illustrated, the fault logic 98 can be an OR gate that can asset the fault signal when a circuit fault is detected using any of the fault detection circuitry of the SBET voltage modulator 90. The control logic 99 can cause all of the MOSFET switches 42, 44, and 46 to provide EBC protection in response to the fault signal being asserted. The control logic 99 can cause any suitable subset of the MOSFET switches 42, 44, and 46 to turn off to electrically isolate a power supply 24A and/or 24B from a circuit fault in response to the fault signal being asserted. In such a case, some of the MOSFET switches 42, 44, and 46 may already be turned off and maintained in a cut off state.

The SBET voltage modulator 90 is also depicted with a ternary level control input CONTROL pin, bidirectional no fault FAULT pin, and bidirectional voltage VIMON pin. The ternary control input CONTROL is used to enable the first supply voltage VDD1 to output node SW connection, to enable the second supply voltage VDD2 to output node SW connection, or to disconnect the output node SW from both the first supply voltage VDD1 and the first supply voltage VDD2. Comparators 103 and 104 and control logic 99 can be used to determine which of MOSFET switches 42, 44, and 46 to turn and which of the MOSFET switches to turn off. This can implement functionality of the decoder 35 of Figure 3. The control logic 99 can provide signals to gates of the MOSFET switches 42, 44, 46, 72, and 92 to implement functionality of the SBET voltage modulator 90. The control logic 99 can provide signals to gates of the MOSFET switches 95 and 96 for fault detection functionality. The control input CONTROL can be received, for example, from the RF and SBET control block 26 of the example MIMO radio system 20 of Figure 2. The control signal can be provided to the comparators 103 and 104 via a voltage divider 102. The bidirectional no fault F̅A̅U̅L̅T̅ pin can pulls low when the ECB has tripped. A pull down MOSFET 101 can assert the active low no fault signal F̅A̅U̅L̅T̅ in response to a fault being detected.

The ECB may be configured to latch-off or automatically retry after an overcurrent fault. The amount of time the between retry events may be long enough to ensure that any residual heat from the overcurrent fault has dissipated. If configured for automatic retry, the ECB may latch-off after a predetermined number of retry events. If the ECB has latched-off, it may be possible to reset the ECB using an additional input and/or by power cycling the SBET voltage modulator 90.

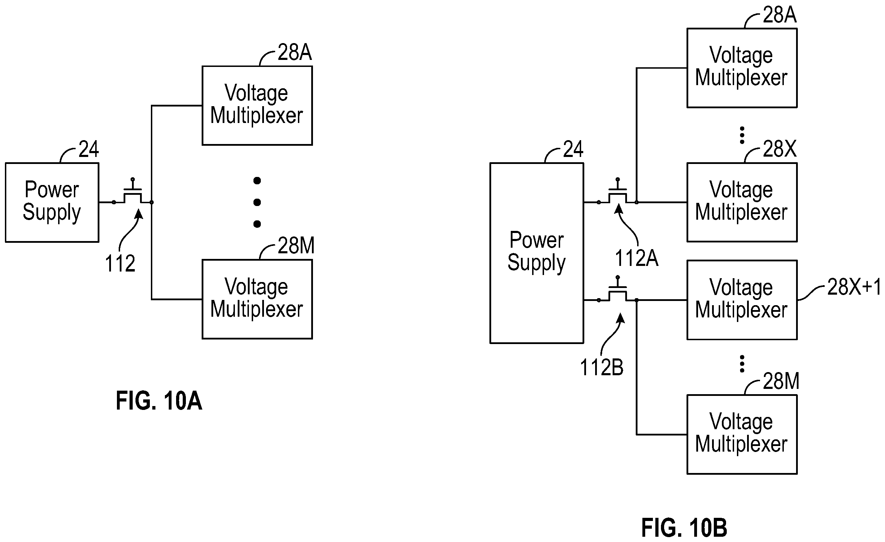

In certain applications, redundant fault protection is desired. For redundant fault protection, a fault protection device and a voltage modulator with fault protection can be implemented. Figures 10A and 10B illustrate examples of redundant fault protection.

Figure 10A illustrates part of a SBET system where a fault protection device 112 can electrically isolate a power supply 24 from voltage multiplexers 28A to 28M in response to a circuit fault being detected. The fault protection device 112 can be a transistor, such as a MOSFET. One or more of the voltage multiplexers 28A to 28M can implement fault detection in accordance with any suitable principles and advantages disclosed herein. For example, each of the voltage multiplexers 28A to 28M can implement fault detection in accordance with any suitable principles and advantages disclosed herein. The fault protection device 112 together with the voltage multiplexers 28A to 28M can provide redundant fault detection.

Figure 10B illustrates part of a SBET system where fault protection devices 112A and 112B can each electrically isolate a power supply 24 from a subset of the voltage multiplexers 28A to 28M. The fault protection device 112A can electrically isolate the power supply 24 from voltage multiplexers 28A to 28X in response to a circuit fault being detected. Such a circuit fault can be associated with a power amplifier that is biased by an output voltage provided by one of the voltage multiplexers 28A to 28X. While the fault protection device 112A is electrically isolating the power supply 24 from a circuit fault, the power supply 24 can provide a supply voltage to the voltage multiplexers 28X+1 to 28M. The fault protection device 112B can electrically isolate the power supply 24 from voltage multiplexers 28X+1 to 28M in response to a circuit fault being detected. Such a circuit fault can be associated with a power amplifier that is biased by an output voltage provided by one of the voltage multiplexers 28X+1 to 28M. While the fault protection device 112B is electrically isolating the power supply 24 from a circuit fault, the power supply 24 can provide the supply voltage to the voltage multiplexers 28A to 28X.

Any of the switches of the voltage modulators disclosed herein can be split into sub-switches with magnetic field cancellation. Magnetic field cancellation can be implemented by current loops that generate magnetic fields in opposite directions. The sub-switches can include a pair of switches that are included in current loops with different bypass capacitors. The current loops can generate magnetic fields having opposite directions for magnetic field cancellation.

Although embodiments disclosed herein may be discussed with reference to MOSFET switches, any other suitable switches can alternatively or additionally be implemented in accordance with any suitable principles and advantages disclosed herein. Such switches can include without limitation transistors, field effect transistors, complementary metal oxide semiconductor (CMOS) transistors, junction field effect transistors, integrated gate bipolar transistors, diode switches, microelectromechanical systems switches, or the like.

Although embodiments disclosed herein may be discussed with reference to power amplifier field effect transistors and modulating a drain voltage for symbol-based envelope tracking, any suitable principles and advantages disclosed herein can be implemented with power amplifiers having a different type of power amplifier transistor output stage. In some applications, a power amplifier in a symbol-based envelope tracking system in accordance with any suitable principles and advantages disclosed herein can include without limitation complementary metal oxide semiconductor (CMOS) transistors, a bipolar transistor, a heterojunction bipolar transistor, or the like. Where a power amplifier includes a bipolar power amplifier transistor, symbol-based envelope tracking can modulate a bias voltage at a collector of the bipolar power amplifier transistor and/or any other suitable teachings applied to a drain can be applied to a collector. A power amplifier transistor can be implemented by any suitable transistor technology for a particular application. Example power amplifier transistors include, but are not limited to, GaN transistors, silicon transistors, silicon-on-insulator transistors, SiGe transistors, GaAs transistors, SiC transistors, InP transistors, or the like.

Although embodiments disclosed herein may be discussed with reference to SBET voltage modulators with 2 voltage supplies or 4 voltage supplies, any suitable principles and advantages disclosed herein can be applied to SBET voltage modulators with a different number of voltage supplies.

### Conclusion

In the embodiments described above, apparatus, systems, and methods for power amplifier systems and/or SBET voltage modulators are described in connection with particular embodiments. It will be understood, however, that the principles and advantages of the embodiments can be used for any other systems, apparatus, or methods with a need for a voltage modulator and/or envelope tracking disclosed herein. Moreover, any suitable principles and advantages disclosed herein can be implemented in systems and in methods that include a power amplifier amplifying a radio frequency signal for transmission via an antenna.

The principles and advantages described herein can be implemented in various apparatuses. Examples of such apparatuses can include, but are not limited to, communications infrastructure such as wireless or wired communications infrastructure, consumer electronic products, parts of the consumer electronic products, electronic test equipment, vehicular electronic products, industrial electronic products, etc. Electronic products can include, but are not limited to, base stations such as cellular base stations, access points, repeaters, relays, wireless communication devices, a mobile phone (for example, a smart phone), a hand-held computer, a tablet computer, a laptop computer, a wearable computing device, a vehicular electronics system, a radio, a wearable health monitoring device, an Internet of Things (IoT) device, etc. Further, apparatuses can include unfinished products.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all the following interpretations of the word: any of the items in the list, all the items in the list, and any combination of the items in the list. All numerical values provided herein are intended to include similar values within a measurement error.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states.

The teachings provided herein can be applied to other systems, not necessarily the systems described above. The elements and acts of the various embodiments described above can be combined to provide further embodiments. The acts of the methods discussed herein can be performed in any order as appropriate. Moreover, the acts of the methods discussed herein can be performed serially or in parallel, as appropriate.

While certain embodiments have been described, these embodiments have been presented by way of example only and are not intended to limit the scope of the disclosure. Indeed, the novel methods and systems described herein may be embodied in a variety of other forms. Furthermore, various omissions, substitutions, and changes in the form of the methods and systems described herein may be made without departing from the spirit of the disclosure. For example, while the disclosed embodiments are presented in given arrangements, alternative embodiments may perform similar functionalities with different components and/or circuit topologies, and some elements may be deleted, moved, added, subdivided, combined, and/or modified. Each of these elements may be implemented in a variety of different ways as suitable. Any suitable combination of the elements and acts of the various embodiments described above can be combined to provide further embodiments. The claims and their equivalents are intended to cover such forms or modifications as would fall within the scope and spirit of the disclosure.

There follows a list of numbered features defining particular embodiments of the present disclosure. Where a numbered feature refers to one or more earlier numbered features then those features should be considered together in combination with each other.
1. A system with symbol-based envelope tracking and fault protection, the system comprising:
   a power amplifier configured to amplify a radio frequency signal; and
   a symbol-based envelope tracking voltage modulator configured to receive a plurality of supply voltages and to provide a bias voltage to the power amplifier, the bias voltage corresponding to a selected one of the plurality of supply voltages, and the symbol-based envelope tracking voltage modulator comprising:
      switches configured to provide the bias voltage and to provide electric circuit breaker protection; and
      a fault detection circuit coupled to at least a first switch of the switches, the fault detection circuit configured to detect a circuit fault and to cause the first switch to provide electric circuit breaker protection in response to detecting the circuit fault.
2. The system of feature 1, further comprising a plurality of voltage supplies configured to provide the plurality of supply voltages, the plurality of voltage supplies comprising a first voltage supply connected to the first switch, the first switch configured to electrically isolate the first voltage supply from the power amplifier in response to the fault detection circuit detecting the circuit fault.
3. The system of features 1 or 2, wherein the fault detection circuit is coupled to a second switch of the switches, the fault detection circuit is configured to detect a second circuit fault and to cause the second switch to provide electric circuit breaker protection in response to detecting the second circuit fault.
4. The system of any of features 1 to 3, further comprising:
   a plurality of additional power amplifiers; and
   a plurality of additional symbol-based envelope tracking voltage modulators each configured to selectively provide a first supply voltage of the plurality of supply voltages to a respective power amplifier of the plurality of additional power amplifiers while the first switch provides electric circuit breaker protection associated with the first supply voltage.
5. The system of any of features 1 to 4, wherein the circuit fault is an overcurrent fault associated with the power amplifier.
6. The system of any of features 1 to 5, wherein the fault detection circuit comprises a comparator.
7. The system of feature 5, wherein the fault detection circuit comprises a replica switch of the first switch.
8. The system of any of features 1 to 7, wherein the fault detection circuit comprises a sense resistor in series between the first switch and the power amplifier.
9. The system of any of features 1 to 8, wherein the first switch comprises a metal oxide field effect transistor.
10. The system of any of features 1 to 9, wherein the first switch comprises back-to-back field effect transistors to junction isolate an input node of the symbol-based envelope tracking voltage modulator from an output node of the symbol-based envelope tracking voltage modulator.
11. The system of any of features 1 to 10, wherein the power amplifier comprises a gallium nitride power amplifier transistor.
12. A method of fault protection in a power amplifier system, the method comprising:
   providing, with a voltage modulator, a first supply voltage as a bias voltage for a power amplifier in a first state using a first switch;
   providing, with the voltage modulator, a second supply voltage as the bias voltage for the power amplifier in a second state using a second switch, wherein the first and second supply voltages are non-zero voltages;
   in the second state, detecting a circuit fault associated with the power amplifier; and
   in response to said detecting, electrically isolating a voltage supply that generates the second supply voltage from the power amplifier using the second switch.
13. The method of feature 8, further comprising providing the second supply voltage to a plurality of other power amplifiers using other voltage modulators during said electrically isolating.
14. The method of features 8 or 13, wherein the circuit fault is an overcurrent fault.
15. The method of any of features 8 to 14, wherein the second switch comprises back-to-back transistors that junction isolate the voltage supply from an output node of the voltage modulator.
16. The method of any of features 8 to 15, wherein the bias voltage tracks an envelope of a radio frequency signal amplified by the power amplifier on a symbol-by-symbol basis.
17. A voltage modulator with fault protection, the voltage modulator comprising:
   input nodes comprising a first input node configured to receive a first supply voltage and a second input node configured to receive a second supply voltage, wherein the first and second supply voltages are non-zero voltages;
   an output node;
   a first switch configured to pass the first supply voltage to the output node in a first state;
   a second switch configured to pass the second supply voltage to the output node in a second state; and
   a fault detection circuit coupled to at least the first switch, the first switch configured to electrically isolate the first input node from the output node in response to an output signal of the fault detection circuit indicating a circuit fault.
18. The voltage modulator of feature 13, wherein the fault detection circuit comprises a comparator.
19. The voltage modulator of feature 13 or 18, wherein the fault detection circuit comprises a replica of the first switch.
20. The voltage modulator of any of features 13 to 19, wherein a voltage at the output node is configured to track an envelope of a radio frequency signal on a symbol-by-symbol basis.

## Claims

1. A system with symbol-based envelope tracking and fault protection, the system comprising:
a power amplifier configured to amplify a radio frequency signal; and
a symbol-based envelope tracking voltage modulator configured to receive a plurality of supply voltages and to provide a bias voltage to the power amplifier, the bias voltage corresponding to a selected one of the plurality of supply voltages, and the symbol-based envelope tracking voltage modulator comprising:
switches configured to provide the bias voltage and to provide electric circuit breaker protection; and
a fault detection circuit coupled to at least a first switch of the switches, the fault detection circuit configured to detect a circuit fault and to cause the first switch to provide electric circuit breaker protection in response to detecting the circuit fault.

2. The system of Claim 1, further comprising a plurality of voltage supplies configured to provide the plurality of supply voltages, the plurality of voltage supplies comprising a first voltage supply connected to the first switch, the first switch configured to electrically isolate the first voltage supply from the power amplifier in response to the fault detection circuit detecting the circuit fault.

3. The system of Claims 1 or 2, wherein the fault detection circuit is coupled to a second switch of the switches, the fault detection circuit is configured to detect a second circuit fault and to cause the second switch to provide electric circuit breaker protection in response to detecting the second circuit fault.

4. The system of any of Claims 1 to 3, further comprising:
a plurality of additional power amplifiers; and
a plurality of additional symbol-based envelope tracking voltage modulators each configured to selectively provide a first supply voltage of the plurality of supply voltages to a respective power amplifier of the plurality of additional power amplifiers while the first switch provides electric circuit breaker protection associated with the first supply voltage.

5. The system of any of Claims 1 to 4, wherein the fault detection circuit comprises at least one or more of:
a) a comparator;
b) a replica switch of the first switch; and/or
c) a sense resistor in series between the first switch and the power amplifier.

6. The system of any of Claims 1 to 5, wherein the first switch comprises one or more of:
a) a metal oxide field effect transistor; and/or
b) back-to-back field effect transistors to junction isolate an input node of the symbol-based envelope tracking voltage modulator from an output node of the symbol-based envelope tracking voltage modulator.

7. The system of any of Claims 1 to 6, wherein the power amplifier comprises a gallium nitride power amplifier transistor.

8. A method of fault protection in a power amplifier system, the method comprising:
providing, with a voltage modulator, a first supply voltage as a bias voltage for a power amplifier in a first state using a first switch;
providing, with the voltage modulator, a second supply voltage as the bias voltage for the power amplifier in a second state using a second switch, wherein the first and second supply voltages are non-zero voltages;
in the second state, detecting a circuit fault associated with the power amplifier; and
in response to said detecting, electrically isolating a voltage supply that generates the second supply voltage from the power amplifier using the second switch.

9. The method of Claim 8, further comprising providing the second supply voltage to a plurality of other power amplifiers using other voltage modulators during said electrically isolating.

10. The system of any of claims 1 to 7 or the method of Claims 8 or 9, wherein the circuit fault is an overcurrent fault associated with the power amplifier.

11. The method of any of Claims 8 to 10, wherein the second switch comprises back-to-back transistors that junction isolate the voltage supply from an output node of the voltage modulator.

12. The method of any of Claims 8 to 11, wherein the bias voltage tracks an envelope of a radio frequency signal amplified by the power amplifier on a symbol-by-symbol basis.

13. A voltage modulator with fault protection, the voltage modulator comprising:
input nodes comprising a first input node configured to receive a first supply voltage and a second input node configured to receive a second supply voltage, wherein the first and second supply voltages are non-zero voltages;
an output node;
a first switch configured to pass the first supply voltage to the output node in a first state;
a second switch configured to pass the second supply voltage to the output node in a second state; and
a fault detection circuit coupled to at least the first switch, the first switch configured to electrically isolate the first input node from the output node in response to an output signal of the fault detection circuit indicating a circuit fault.

14. The voltage modulator of Claim 13, wherein the fault detection circuit comprises one or more of:
a) a comparator; and/or
b) a replica of the first switch.

15. The voltage modulator of any of Claims 13 or 14, wherein a voltage at the output node is configured to track an envelope of a radio frequency signal on a symbol-by-symbol basis.
